Europäisches Patentamt

European Patent Office

Office européen des brevets

(11) Publication number: **0 321 860**
**A2**

# EUROPEAN PATENT APPLICATION

(21) Application number: 88120975.3

(22) Date of filing: 15.12.88

(51) Int. Cl.⁴ **H01L 21/82 , H01L 21/31 , H01L 27/06**

(30) Priority: 23.12.87 IT 2320087

(43) Date of publication of application:
28.06.89 Bulletin 89/26

(84) Designated Contracting States:
DE FR GB NL SE

(71) Applicant: SGS-THOMSON
MICROELECTRONICS s.r.l.
Via C. Olivetti, 2
I-20041 Agrate Brianza Milan(IT)

(72) Inventor: Re, Danilo
Via Emilia 4
I-20044 Bernareggio Milano(IT)

(74) Representative: Modiano, Guido et al
MODIANO, JOSIF, PISANTY & STAUB
Modiano & Associati Via Meravigli, 16
I-20123 Milan(IT)

(54) **Process for manufacturing integrated capacitors in mos technology.**

(57) A process for manufacturing integrated capacitors in CMOS technology, comprising the steps of: producing, in a substrate (1) of semiconductor material having a first type of conductivity, at least one well (4) with the opposite type of conductivity, defining the active areas, producing insulation regions (3, 3'), depositing a first conducting layer (6) of polycrystalline silicon adapted to form the gate regions and the lower plates of the capacitors, depositing a layer (7) of silicon oxide at low temperature, to form the dielectric of the capacitors, depositing a second layer (8) of polycrystalline silicon to form the second plate of the capacitors, shaping the polycrystalline silicon and silicon oxide layers, implanting and diffusing the source (9) and drain (10) regions of the CMOS transistors, providing the insulation layer (11), the metallic connecting layer (12), and final covering with a layer of protective insulation.

FIG. 3

# PROCESS FOR MANUFACTURING INTEGRATED CAPACITORS IN MOS TECHNOLOGY

The present invention relates to a process for manufacturing integrated capacitors in MOS technology. in particular in CMOS technology.

As is known, in recent years CMOS technology. and in particular the CMOS technology employing polycrystalline silicon gates (CMOS-SILICON GATE) has made considerable progress, ensuring high integration levels and low power consumption. becoming increasingly common in the production of complex digital circuits of the VLSI generation.

More recently. these advantageous characteristics of CMOS technology have been found useful also for the production of many devices for analog applications.

Good control of the processes in fact allows to obtain a degree of precision and reproducibility of the integrated components which is adequate for the requirements of this class of devices.

One of the components for which considerable precision is required is the capacitor; its main requirements are: small size, precise capacity value, low current loss and most important low voltage coefficient (i.e. low percentual capacity variation according to the voltage applied to the electrodes). In many designs the maximum value required for this last parameter is approximately 20 ppm/volt.

The production of capacitors must furthermore meet the following requirements: it must be implementable within a process currently in production without causing modifications to the other integrated components (transistors, resistors, etc.), it must not cause limitations in the degree of integration in more advanced processes currently being developed (i.e. it must have no effect on design tolerances); and it must entail the smallest possible cost increase.

Capacitors which can be integrated in a CMOS-type silicon-gate circuit are currently manufactured according to one of the following three processes.

According to a first process, MOS-type capacitors are obtained as a secondary product in the CMOS manufacturing process. In particular, one electrode of the capacitor is formed by the silicon substrate and the other is formed by a layer of polycrystalline silicon which is also used to produce the gate regions of the CMOS devices. The dielectric is here formed by the gate oxide layer. This type of capacitor naturally does not affect the rest of the process, since its execution is intrinsic to the normal flow of a CMOS process. However, the problem of this type of capacitor resides in the fact that it has a high voltage coefficient, so that it is absolutely unusable as a capacitor in a precision analog circuit.

A second process produces capacitors similarly to the previous one, with the difference that the lower electrode is formed by a heavily doped region inside the substrate. This second solution requires an additional mask with respect to the known CMOS process, but has no other effect on the process. The production cost of such a capacitor is furthermore modest; however, the voltage coefficient is not always adequate for the levels required by analog applications, as values above 300 ppm/volt are obtained. Consequently it is not always applicable.

The third possibility is to produce capacitors the electrodes whereof are formed by two layers of polycrystalline silicon separated by a layer of oxide obtained by thermal oxidation and forming the dielectric. This type of capacitor. which is in widespread use, meets the necessary requirements in terms of precision, voltage coefficient, relative simplicity and low production cost, but it is not free from disadvantages. In fact in a typical silicon-gate CMOS process all the thermal treatments are appropriately dimensioned. defined, and any addition of steps at temperatures capable of diffusing doping species can cause alterations in the produced structures which may compromise the operation of the produced devices. On the other hand the oxidation temperature of the polycrystalline silicon must be higher than $1000^\circ$ C (and typically than $1100^\circ$ C) in order to obtain low-defect oxides. This thermal treatment actuates a displacement of the doping ion species contained in the insulation regions, facilitating their diffusion in the areas where the transistors are manufactured, as a consequence of the moment in which it is performed (i.e. after the active areas of the transistors are formed).

The effect of these diffusions is to decrease the effective surface of the active areas, having as consequence the so-called "narrowing" effects on the transistors and an unwanted increase of the threshold voltages thereof. While using the minimum-area geometries technology, the above mentioned phenomenon can lead to a failure of the manufactured devices, as these no longer comply with their design specifications.

In order to compensate such effects, it is currently necessary to redefine the parameters of the thermal treatments of the entire process, taking into account those added for the capacitors. this besides requiring long adjustment operations, entailing the need to modify the minimum design tolerances and increasing the minimum width allowed to the transistors. This naturally reduces the integration level of the process.

Given this situation, the aim of the present invention is to provide a process for manufacturing capacitors which solves the shortcomings of the known art and in particular allows to manufacture capacitors having electric characteristics which comply with the specifications, in particular with those relative to the voltage coefficient, and which at the same time do not affect other components of the devices in which they are integrated and do not set lower limits to the minimum obtainable dimensions.

Within the scope of this aim, a particular object of the present invention is to provide a process which produces capacitors with thoroughly controllable electric characteristics complying with the set requirements.

Not least object of the present invention is to provide a process which comprises per se well-known and tested process steps to allow the use of machines commonly used in the electronics industry, with controllable results and with a cost comparable to that of the known art.

This aim, these objects and others which will become apparent hereinafter are achieved by a process for manufacturing integrated capacitors in MOS technology, as defined in the accompanying claims.

Further characteristics and advantages of the invention will become apparent from the description of a preferred but not exclusive embodiment, illustrated only by way of non-limitative example in the accompanying drawings, wherein:

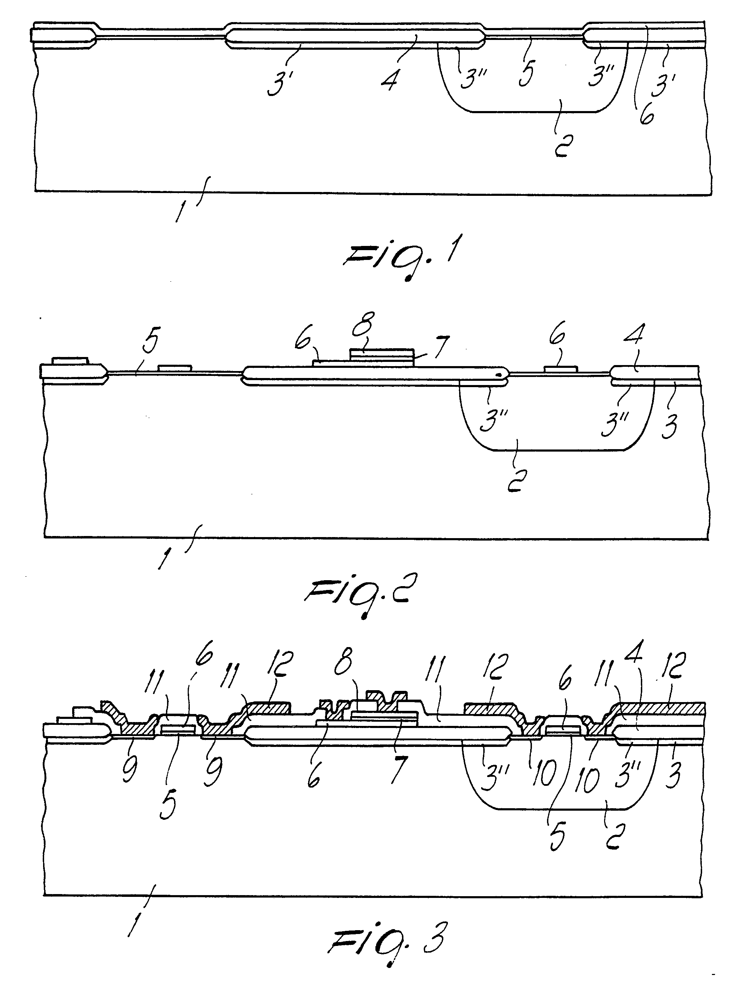

figures 1 to 3 are transverse sectional views through a silicon wafer, illustrating different successive steps of the process according to the invention, in CMOS technology.

The process according to the invention initially comprises conventional process steps to manufacture, in a body or substrate 1 of semiconductor material having a first type of conductivity, at least one well 2 with the opposite type of conductivity, by means of an appropriate masking, doping and diffusion step. Said diffusion is normally performed at high temperature (typically 1200°C) in order to manufacture wells with a considerable junction depth able of accommodating transistors.

Then a layer of inert material (typically silicon nitride) is deposited, masked and shaped so as to define the active areas of the transistors. In particular, the nitride is shaped so as to cover only the active regions in which the transistors are to be provided, leaving free the regions in which the insulations and the field oxide are to be provided. Doping ions adapted to provide a conductivity equal to that of the regions in which they are implanted are subsequently implanted by means of two masking steps in succession, in order to increase their concentration and form insulation regions (channel stoppers).

In these steps the implantations are performed at appropriate energy levels so that, the various areas covered by the inert material which delimits the active areas are shielded.

Field oxidation is then performed, leading to the forming of a silicon oxide layer indicated by the reference numeral 4 in figure 1 only in the regions free from the inert material, simultaneously diffusing all the doping ion species present in the structure, forming the insulation regions 3' in the substrate and 3" in the well. This oxidation is normally performed at temperatures of approximately 1000°C. the effect of displacing the doping species being especially effective in the insulation regions; these doping agents. contrary to those forming the well, have not yet undergone thermal treatments.

The removal of the inert layer and the subsequent thermal oxidation forming gate oxide of the transistors (layer 5) is following. This operation is further followed by the deposition of a layer of polycrystalline silicon 6 on the entire surface of the silicon wafer and by the doping of this layer. The intermediate structure of figure 1 is thus obtained and is thus fully conventional.

This is followed by the process steps leading to the production of the gate electrodes and of the capacitors; in particular the third disclosed process such as known in the art, would entail a masking step to define the gate regions of the transistors and of the lower electrodes of the capacitors. a step of surface thermal oxidation of the polysilicon to form the dielectric of the capacitors, a further deposition of polycrystalline silicon and its doping and shaping in order to delimit the upper plates or the electrodes of the capacitors. However, as mentioned, the thermal oxidation step can lead to a displacement of the doping ion species, producing the already mentioned negative effects.

According to the invention, after depositing the first polycrystalline silicon layer 6, a silicon oxide layer is formed at low temperature, specifically by depositing at a temperature such as not to cause a significant displacement of the doping species.

In detail, according to a preferred embodiment of the invention, the silicon oxide is deposited by oxidation in $O_2$ of tetraethylorthosilicate at 700°C. Due to the relatively low temperature of this process it is thus possible to obtain a film or thin layer of silicon oxide, indicated by 7 in figure 2, conveniently acting is dielectric of the capacitors, its manufacturing causing no alterations in the underlying structure.

The process can thus continue conventionally - with a subsequent deposition of a layer of polycrystalline silicon and related doping, so as to form a layer 8 similar to the layer 6, obtaining a "sandwich" formed by two layers of polycrystalline silicon separated by a film or thin layer of silicon oxide.

A masking step is then conventionally performed on the last layer 8 of the polycrystalline silicon and on the deposited oxide film 7, thus obtaining one of the plates of the capacitors and thus uncovering the surface of the first polysilicon layer 6. A subsequent masking of the first polycrystalline silicon layer 6 defines the gate electrodes of the transistors and simultaneously the second plate of the capacitors. The structure illustrated in figure 2 is thus obtained.

The following process steps comprise two successive masking steps to implant ions in the active areas not covered by polycrystalline silicon to form the source and drain junctions of the transistors. Once the diffusion of the ions implanted in the substrate and in the oppositely doped wells has been performed so as to form the source and drain regions 9 and 10 respectively, the insulating layers are deposited and caused to reflow with an appropriate thermal treatment; consequently the contacts are opened with a masking step, and a metal film or thin layer is deposited and shaped with a second mask, thus obtaining the connections between the various components of the circuit. The structure illustrated in figure 3 is thus obtained; said figure illustrates the insulating layer 11 and the metallic layer 12 used for the connections.

Finally the entire structure is covered with a final protective insulation layer in which the contact regions of the external connections are opened by masking.

In practice, according to the invention, the oxide interposed between the two plates of the capacitors is obtained by means of a low-temperature process which causes no displacement of the doping species and therefore does not alter the other structures. The process of therefore manufacturing integrated capacitors with low voltage coefficient without altering any of the other structures of the device is extremely advantageous, particularly in view of the development of more advanced processes in which a higher level of integration is required.

The fact that the deposition of the silicon oxide at low temperature, according to the present invention, does not require the alteration of any of the CMOS technology process steps is furthermore advantageous, and the provision of the deposited silicon oxide layer can be added to all commonly known CMOS processes simply by inserting the required operations in the usual production steps.

The fact is stressed that the described embodiment, which consists in a deposition by oxidation of

tetraethylorthosilicate in $O_2$, is particularly advantageous as it allows the reduced thicknesses and high uniformity of the dielectric layer required to produce capacitors of appropriate capacity and with the required electric characteristics.

The fact should be furthermore stressed that though several methods for forming silicon oxides at low temperature are known, these methods are currently used in CMOS processes for other purposes (e.g. to form final protection layers, insulation layers between two metallization levels, insulation layers between the polycrystalline silicon layers and the metallic layers) and are not adapted to form the dielectric layer of capacitors due to the high thicknesses obtainable and to their imperfect stoichiometry.

The invention thus conceived is susceptible to numerous modification and variations, all of which are within the scope of the inventive concept. In particular, the fact is stressed that the described embodiment merely constitutes one possible manner of implementing the invention in a silicon-gate CMOS process, but other sequences of operations can be performed to obtain the resulting structure. The invention is furthermore applicable to capacitors the plates whereof are doped with different methods (such as e.g. by vapors composed of the doping agents for ion implantation or even with other less conventional methods).

The invention furthermore comprises the variation in which the plates of the capacitors are not both provided by means of an appropriately doped polycrystalline silicon layer but are manufactured e.g. one by means of a polycrystalline silicon layer and the other by the metallic layer (typically aluminum) used for the connections. Obviously this solution entails a sequence of operations which is thoroughly different from the one described in the example, but is still based on forming by deposition of silicon oxides at low temperature in order to manufacture the dielectric layer of the capacitors. It is obvious that in this case the above mentioned characteristic is even more important, since the dielectric is manufactured at a more advanced stage of the production process, so that the altering influence of said process is higher on the already manufactured structures.

The fact must furthermore be stressed that the process according to the invention is implementable in the production processes of integrated capacitors in NMOS and PMOS technology, since these can be considered as subsets of the disclosed CMOS process.

It is furthermore stressed that all the technical details may be replaced with other technically equivalent ones.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. Process for manufacturing integrated capacitors in MOS technology, comprising the steps of: producing, in a substrate (1) of semiconductor material having a first type of conductivity, a first layer (6) of conducting material to form a first plate, providing a layer (7) of dielectric material at least partially superimposed and in contact with said first layer (6) of conducting material, and providing a second layer (8) of conducting material superimposed and in contact with said layer (7) of dielectric material, to form the second plate of the capacitor, characterized in that the provision of said layer (7) of dielectric material comprises the step of depositing the dielectric material at low temperature.

2. Process according to claim 1, characterized in that said step of depositing the dielectric material comprises the deposition of a silicon oxide layer at low temperature.

3. Process according to the preceding claims, characterized in that said depositing step comprises the oxidation of tetraethylorthosilicate in $O_2$ at temperatures comprised between 650 and 750°C.

4. Process according to one or more of the preceding claims, characterized in that said first (6) and second (8) layers of conducting material comprise a layer of doped polycrystalline silicon.

5. Process according to one or more of claims 1-3, characterized in that said first layer (6) of conducting material comprises a layer of doped polycrystalline silicon and said second layer (8) of conducting material comprises a connecting metallic layer.

EP 0 321 860 A2

Fig. 1

Fig. 2

Fig. 3